# FASCICULE DE BREVET EUROPEEN

(11) **EP 0 851 417 B1**
(45) Date de publication et mention de la délivrance du brevet: **04.09.2002**
(21) Numéro de dépôt: 97403118.9
(22) Date de dépôt: 22.12.1997
(51) Int. Cl.: G11B 9/00, G11B 9/04

(54) **Système et procédé de lecture d'informations**
Vorrichtung und Verfahren zur Wiedergabe von Informationen
System and procedure for reading an information recording carrier

(30) Priorité: 26.12.1996 FR 9616036
(43) Date de publication de la demande: 01.07.1998
(73) Titulaire: COMMISSARIAT A L'ENERGIE ATOMIQUE, 75015 Paris (FR)
(72) Inventeur: Clerc, Jean-Frédéric, 38120 Le Fontanil (FR); Bechevet, Bernard, 38640 Claix (FR)
(74) Mandataire: Signore, Robert

(56) Documents cités:
- EP-A- 0 184 189
- EP-A- 0 363 147
- EP-A- 0 378 443
- EP-A- 0 665 541
- WO-A-89/12302
- WO-A-94/05011
- FR-A- 1 391 259
- US-A- 3 801 966
- US-A- 3 833 894
- US-A- 4 139 908
- H. FLEISHER ET AL.: "STORAGE ELEMENT FOR MACHINE USE" IBM TECHNICAL DISCLOSURE BULLETIN, vol. 14, no. 12, mai 1972, ARMONK, N.Y., US, pages 3581-3582, XP002039943

## Description

### Domaine technique

La présente invention a pour objet un support d'enregistrement, un dispositif de lecture de ce support et des procédés de mise en oeuvre de ce dispositif. Elle trouve une application dans l'enregistrement d'informations, celles-ci pouvant représenter des images, des sons, des données, etc...

L'invention peut s'appliquer notamment à la télévision et à la réalisation de mémoires d'ordinateur.

### Etat de la technique antérieure

L'enregistrement d'informations au moyen d'une micropointe agissant sur un support approprié est déjà connu. Par micropointe, on entend une pointe mécanique dont la taille est inférieure à environ un micromètre. Ces pointes sont en général conductrices de l'électricité. Un courant circulant entre une telle pointe et un support provoque un échauffement local de celui-ci, ce qui peut entraîner une modification de la structure du support, et, par exemple, le faire passer d'un état cristallin à un état amorphe. C'est l'opération d'écriture. La mesure ultérieure de la caractéristique du matériau (cristallin ou amorphe), par exemple par l'intermédiaire de sa conductivité, constitue l'opération de lecture.

Cette technique est appelée quelquefois "enregistrement à changement de phase". Elle conduit à une haute densité d'information. La pointe utilisée est alors une pointe du genre de celles qu'on trouve dans les sondes de microscopie atomique ("Atomic Force Microscope" en anglais, ou AFM en abrégé).

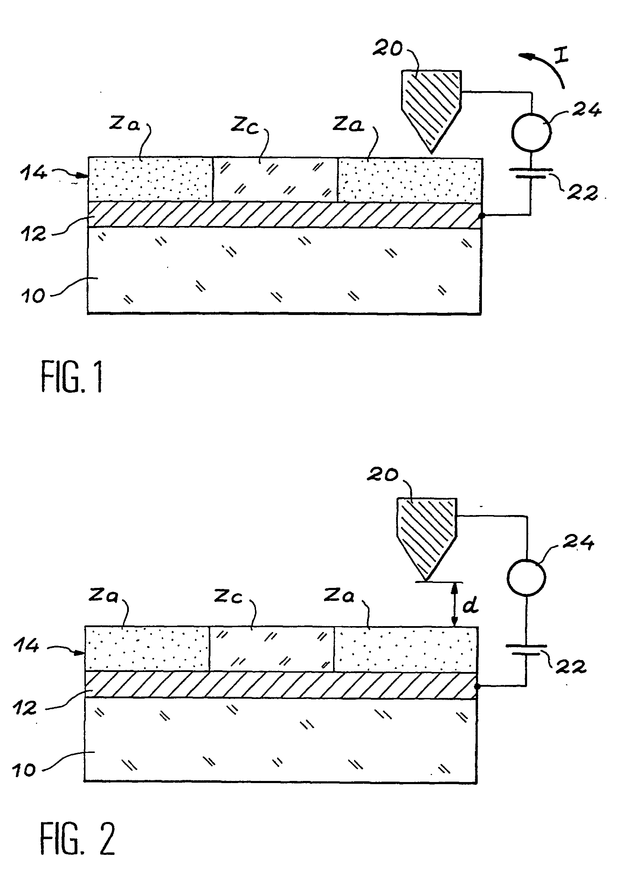

La figure 1 annexée illustre cette technique. On y voit un substrat 10 recouvert d'une couche conductrice 12 servant d'électrode et une couche d'enregistrement 14. Cette couche contient des zones où le matériau est soit à l'état amorphe (zones Za), soit à l'état cristallin (zones Zc). Une micropointe 20 vient au contact de ces zones. Une source de tension V est reliée à la micropointe 20 et à l'électrode enterrée 12. Elle permet de faire passer un courant I dans l'ensemble, courant qui est mesuré par le moyen 24.

Le courant I prend deux intensités, respectivement la et Ic, selon que la zone testée est amorphe (Za) ou cristalline (Zc). La résistance de la couche d'enregistrement 14 prend en effet deux valeurs, respectivement Ra et Rc, selon l'état amorphe ou cristallin du matériau. En pratique, la résistance Ra est plus faible que la résistance Rc. On a donc :
- Ia=V/Ra, si la couche d'enregistrement est amorphe,
- Ic=V/Rc, si la couche d'enregistrement est cristalline.

La distinction entre les deux états est d'autant plus aisée que le rapport Ra/Rc est plus élevé.

Une telle technique est décrite dans EP-A-0 665 541.

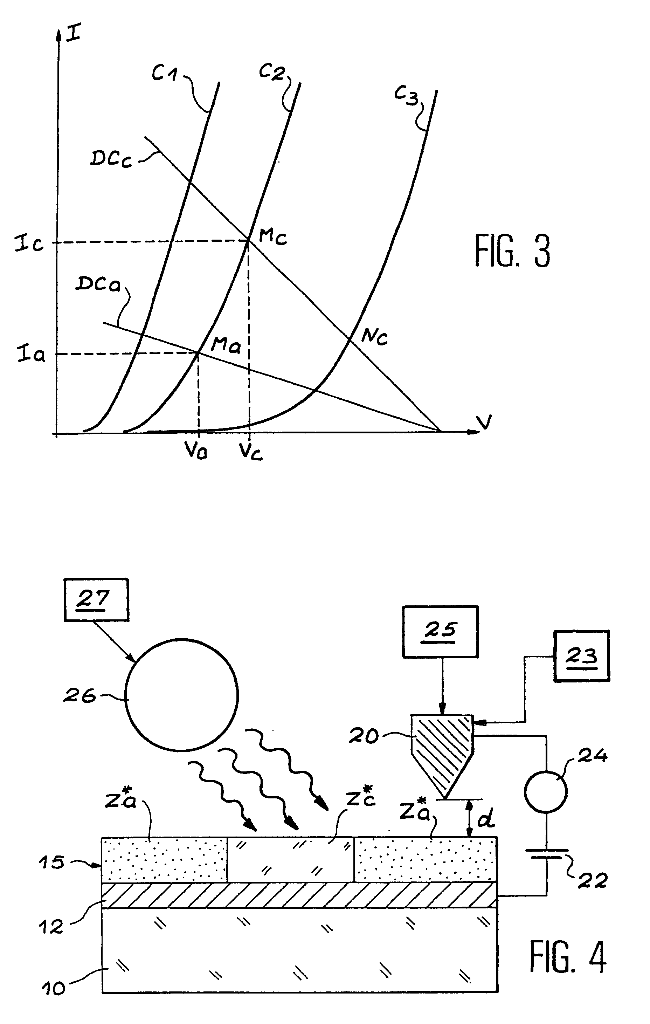

Les figures 2 et 3 illustrent une autre méthode de lecture d'un tel support, faisant appel à l'effet tunnel. Le support est toujours constitué d'un substrat 10, d'une électrode enterrée 12 et d'une couche d'enregistrement 14, et le dispositif de lecture comprend encore une micropointe 20, une source 22 et un moyen de mesure 24, mais la micropointe 20 est maintenant écartée de la couche 14 d'une distance d. Malgré cet intervalle, un courant peut encore pénétrer dans la couche d'enregistrement, par effet tunnel.

Pour déterminer la valeur à laquelle s'établit l'intensité du courant, il faut avoir recours à un diagramme courant-tension. C'est ce qui est représenté sur la figure 3. Sur ce diagramme, la tension est portée en abscisses et le courant en ordonnées. La caractéristique courant-tension est une courbe présentant un coude, comme pour les diodes tunnel. Trois caractéristiques C1, C2, C3 sont tracées sur la figure 3, correspondant à trois distances différentes d1, d2, d3 entre la pointe et la couche d'enregistrement. Pour une même tension, le courant est d'autant plus grand que la distance est plus faible. On a donc, dans le cas illustré, d1<d2<d3.

La droite de charge relie le courant à la tension compte tenu de l'aspect résistif du circuit. Lorsque la zone testée est amorphe, la résistance Ra est forte, et la chute de tension est forte. Pour une zone cristalline, la résistance Rc est plus faible, ainsi que la chute de tension. Les droites de charge se présentent donc comme illustré sur la figure 3, sous les références DCa et DCc, respectivement pour une zone amorphe Za et pour une zone cristalline Zc.

Si l'on considère la caractéristique C2 relative à une distance d2, le point de fonctionnement se situe donc soit en Ma (si la zone est amorphe) soit en Mc (si la zone est cristalline). Le couple courant-tension est alors soit Ia-Va (zone amorphe), soit Ic-Vc (zone cristalline). La mesure du courant permet donc encore de distinguer l'état de la zone testée, donc l'information enregistrée.

Bien que donnant satisfaction à certains égards, ces dispositifs présentent des inconvénients. Le premier, illustré par la figure 1, nécessite un contact entre la pointe et la couche d'enregistrement, ce qui entraîne, à la longue, une usure mécanique de la pointe et des erreurs de lecture. Le second, illustré sur les figures 2 et 3, s'affranchit de ces difficultés mais en rencontre d'autres liées au fait que la mesure est très sensible aux variations de hauteur de la pointe par rapport à la couche d'enregistrement. Comme le montre la figure 3, pour une même tension V, le courant circulant dans une zone (amorphe ou cristalline) dépend beaucoup de la distance d. Une zone cristalline pourrait donc très bien être considérée comme amorphe si la hauteur de la pointe venait à diminuer.

Par le document EP-A-0 378 443, on connaît un support d'enregistrement fondé sur la photoconduction. La couche d'enregistrement est toujours susceptible de prendre un état amorphe ou un état cristallin mais, en plus, cette couche est photoconductrice. Le travail d'extraction des électrons change selon qu'une zone a été illuminée ou non. La lecture s'effectue par collecte des électrons émis sous l'effet d'un rayonnement.

### Exposé de l'invention

Selon l'invention, le support d'enregistrement est du type à photoconducteur mais la lecture s'effectue par la mesure du courant passant dans une micropointe placée au-dessus du support.

De façon plus précise, la présente invention a pour objet un système de lecture d'informations comprenant un support où sont enregistrées lesdites informations, ce support comprenant un substrat, une couche conductrice, une couche d'enregistrement en un matériau apte à présenter, en diverses zones, soit un état amorphe, soit un état cristallin, ce dispositif comprenant en outre au moins une micropointe, des moyens de déplacement de cette micropointe pour placer celle-ci au-dessus de l'une quelconque des zones d'enregistrement du support, des moyens pour faire passer un courant dans la micropointe et dans ladite zone et des moyens pour mesurer l'intensité de ce courant, ce dispositif étant caractérisé en ce que :
i) le matériau de la couche d'enregistrement du support est un matériau photoconducteur, avec une résistivité qui dépend de l'éclairement, ce matériau présentant une première résistance Ra en l'absence d'éclairement et une seconde résistance Ra* en présence d'éclairement pour une zone où le matériau est amorphe, une troisième résistance Rc en l'absence d'éclairement et une quatrième résistance Rc* en présence d'éclairement pour une zone où le matériau est cristallin, le rapport Ra/Ra* étant différent du rapport Rc/Rc* ;
ii) il comprend, en outre, une source lumineuse apte à illuminer au moins la zone du support au-dessus de laquelle la pointe est disposée, des moyens de commande de cette source lumineuse pour produire un état d'éclairement ou un état de non-éclairement de ladite zone.

L'invention permet de discriminer, sans contact, une zone amorphe d'une zone cristalline. Elle permet d'effectuer cette discrimination pour des couches dont l'écart de planéité, sur 100 microns carrés, est de l'ordre de quelques nanomètres, c'est-à-dire trop grand pour effectuer une lecture par effet tunnel.

La distinction entre une zone amorphe et une zone cristalline ne se fonde pas sur la variation de résistance entre l'état amorphe et l'état cristallin, mais sur la variation de résistance entre l'état éclairé et l'état non éclairé, variation qui dépend de l'état du matériau, selon qu'il est amorphe ou cristallin. En d'autres termes, les rapports Ra/Ra* et Rc/Rc* où l'étoile symbolise l'état d'éclairement, doivent être aussi différents que possible. Cette lecture peut très bien s'effectuer sans contact, car la sensibilité à la position de la pointe est moindre que dans l'art antérieur. Mais, naturellement, la lecture peut s'effectuer aussi avec contact.

La présente invention a également pour objet des procédés de mise en oeuvre de ce système. Selon un premier mode de mise en oeuvre, on mesure, pour une zone donnée de la couche d'enregistrement, la variation d'intensité du courant lorsqu'on passe d'un premier état d'éclairement de cette zone à un second état d'éclairement de cette même zone et l'on déduit de cette variation d'intensité la valeur de l'information enregistrée dans cette zone.

Selon un second mode de mise en oeuvre, on mesure, pour une zone donnée de la couche d'enregistrement, la variation de distance entre la micropointe et la couche d'enregistrement qui assure au courant une intensité constante lorsqu'on passe d'un premier état d'éclairement de cette zone à un second état d'éclairement de cette même zone, et l'on déduit de cette variation de distance la valeur de l'information enregistrée dans cette zone.

Pour chacun de ces procédés, on peut lire une zone après l'autre, en portant cette zone alternativement dans un premier état d'éclairement puis dans un second état d'éclairement, ou bien porter l'ensemble du support alternativement dans l'un et l'autre des deux états d'éclairement et lire, pour toutes les zones dans chaque état d'éclairement, la caractéristique retenue (intensité ou distance).

### Brève description des dessins

- la figure 1, déjà décrite, illustre un support d'enregistrement connu et un dispositif connu de lecture avec contact ;
- la figure 2, déjà décrite, illustre un dispositif connu de lecture sans contact ;
- la figure 3, déjà décrite, est un diagramme courant-tension illustrant le fonctionnement du dispositif de la figure 2 ;
- la figure 4 montre un support d'enregistrement selon l'invention, ainsi qu'un dispositif de lecture selon l'invention ;

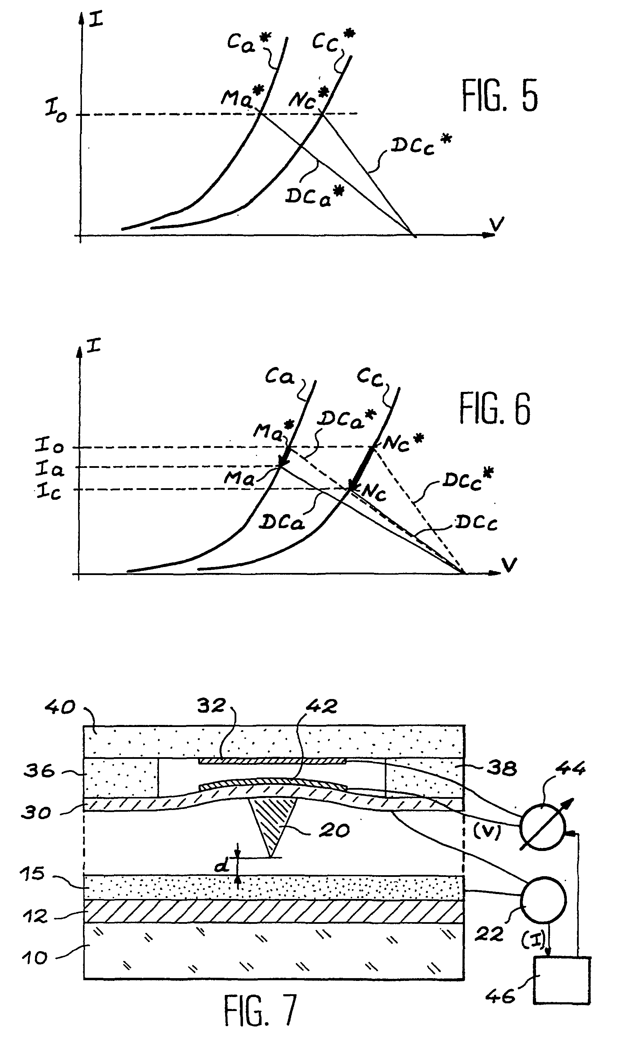

- la figure 5 est un diagramme courant-tension illustrant le réglage de l'intensité à une valeur donnée ;
- la figure 6 est un diagramme courant-tension illustrant la variation d'intensité pour une zone amorphe et pour une zone cristalline ;
- la figure 7 illustre un mode de réalisation d'un dispositif où la distance micropointe-support est réglable ;

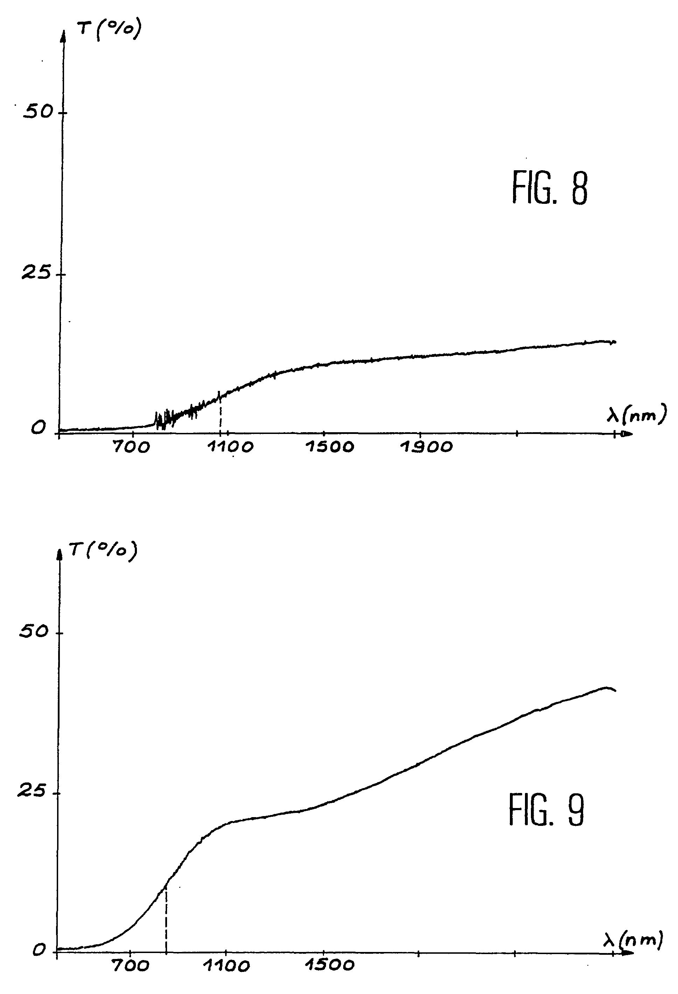

- la figure 8 est un diagramme illustrant le coefficient de transmission d'un matériau photoconducteur, à l'état cristallin, en fonction de la longueur d'onde ;
- la figure 9 est un diagramme illustrant le coefficient de transmission d'un matériau photoconducteur, à l'état amorphe, en fonction de la longueur d'onde.

### Exposé détaillé de modes de réalisation

Dans la description qui suit, on désigne par :
- Ra la résistance d'une zone amorphe sans illumination,
- Ra* la résistance d'une zone amorphe sous illumination,
- Rc la résistance d'une zone cristalline sans illumination,
- Rc* la résistance d'une zone cristalline sous illumination.

La condition à observer pour mettre en oeuvre l'invention est que Ra/Ra* soit différent de Rc/Rc*. Cette condition est généralement vérifiée par les matériaux photoconducteurs, sans précautions particulières sur les conditions de leur obtention. C'est le cas, par exemple, des composés semiconducteurs en silicium ou les composés II-IV ou III-V, ou pour certains alliages.

La figure 4 illustre un support d'enregistrement et un dispositif de lecture selon l'invention. Cette figure reprend des moyens déjà illustrés sur la figure 2 avec les mêmes références. Conformément à l'invention, le support d'enregistrement, qui porte la référence 15, est en matériau photoconducteur. Par ailleurs, le dispositif de lecture comprend, en plus, une source lumineuse 26 apte à éclairer au moins la zone testée, cette source étant commandée par des moyens 27. Le dispositif comprend des moyens 23 aptes à déplacer la micropointe 20 dans deux directions orthogonales, afin de placer la pointe 20 au-dessus de n'importe quelle zone, et des moyens 25 aptes à régler la distance d séparant la micropointe 20 de la couche d'enregistrement 15.

Le rayonnement émis par la source 26 correspond à la bande interdite du matériau photoconducteur, afin de provoquer le phénomène de photoconduction, qui abaisse la résistivité. La couche d'enregistrement 15 comprend donc des zones amorphes ou cristallines, chacune étant soit éclairée, soit non éclairée. Ces zones sont référencées par la suite Za ou Zc pour les zones respectivement amorphes et cristallines non éclairées et Za* ou Zc* pour les zones respectivement amorphes et cristallines mais éclairées.

Dans le mode de mise en oeuvre du procédé qui est illustré sur les figures 4 à 7, la lecture s'effectue en deux phases :
- dans une première phase, qui peut être une phase d'éclairement, le comportement du dispositif est conforme au diagramme de la figure 5 ; ce diagramme est un diagramme courant-tension et montre deux caractéristiques Ca* et Cc*, selon que la zone est amorphe ou cristalline ; deux droites de charge sont également représentées, respectivement DCa* et DCc* ; dans cette première phase, on ajuste la distance (d) séparant la micropointe 20 de la couche d'enregistrement 15 pour obtenir une intensité du courant égale à une valeur donnée Io ; le point de fonctionnement est alors le point Ma* ou Nc*, selon que la zone lue est amorphe ou cristalline ;
- dans une seconde phase, on place la zone lue dans un second état d'éclairement, par exemple sans éclairement dans le cas illustré, et l'on mesure la chute de courant qui en résulte ; le diagramme de la figure 6 illustre le phénomène ; si l'on se trouve au-dessus d'une zone amorphe, la droite de charge passe de la position DCa* à la position DCa, puisque la résistance passe de Ra* à Ra ; le point de fonctionnement glisse de Ma* à Ma et l'intensité tombe de Io à Ia ; si la pointe est située au-dessus d'une zone cristalline, la droite de charge passe de la position DCc* à la position DCc, puisque la résistance passe de Rc* à Rc ; le point de focntionnement passe de Nc* à Nc, et l'intensité tombe de Ia à Ic.

Dès lors que Ra/Ra* est différent de Rc/Rc*, les intensités Ia et Ic sont différentes, et la discrimination entre état amorphe et état cristallin est possible.

Naturellement, on peut opérer en inversant les états d'éclairement, c'est-à-dire en commençant par une première phase sans éclairement et en poursuivant par une seconde phase avec éclairement. On observera alors une augmentation du courant et non une diminution, mais cette variation sera toujours suffisante pour discriminer une zone amorphe d'une zone cristalline.

Dans une autre variante, on travaille à intensité de courant constante (Io) et l'on mesure, avec et sans éclairement, les distances micropointe 20-couche d'enregistrement 15, qui conduisent à cette même intensité. La discrimination s'effectue alors sur les écarts de distance observés.

Comme dans la première mise en oeuvre, on peut procéder en deux phases :
- dans une première phase, on place la zone à lire dans un premier état d'éclairement (éclairement ou non éclairement) et on règle la distance séparant la micropointe 20 de la couche d'enregistrement 15 à une première valeur d1 pour obtenir une intensité égale à une valeur donnée Io,
- dans une seconde phase, on place la zone à lire dans un second état d'éclairement (non éclairement ou éclairement) et l'on règle à nouveau la distance séparant la micropointe 20 de la couche d'enregistrement 15 à une seconde valeur d2 pour oubtenir la même intensité Io, et l'on déduit de l'écart entre la première valeur d1 et la seconde d2 l'information enregistrée.

Dans les deux procédés, on peut opérer soit une zone après l'autre, en passant, pour chaque zone, d'un état d'éclairement à l'autre, soit en plaçant toutes les zones dans un premier état d'éclairement puis toutes les zones dans un second état d'éclairement.

La figure 7 illustre un exemple de réalisation des moyens de réglage de la distance "d" entre la micropointe 20 et la couche d'enregistrement 15. Ces moyens comprennent une membrane flexible 30, sous laquelle est fixée la micropointe 20, une électrode 32 fixée sur la face supérieure de la membrane, une autre électrode 34, deux câles d'épaisseur 36, 38, une lame rigide 40 et une seconde électrode 42 fixée sous la lame 40. Les deux électrodes 32 et 42 sont reliées aux deux pôles d'une source de tension 44. Le réglage de la tension V produite par la source 44 permet d'ajuster la force électrostatique agissant entre les deux électrodes 32, 42, donc de régler la déformation de la membrane 30. L'ajustage de la tension s'effectue par une unité de traitement centrale 46 qui reçoit, par ailleurs, la valeur de l'intensité du courant traversant la micropointe. Cette unité 46 règle la tension de telle manière que le courant ait une intensité appropriée (Io). Ce réglage de la hauteur est effectué pour un premier état d'éclairement. Il peut être maintenu pour le second état d'éclairement, auquel cas l'unité 46 lit la variation d'intensité obtenue lorsqu'on place la zone dans un second état d'éclairement. Selon une variante, l'unité de traitement 46 maintient l'intensité du courant à une même valeur pour les deux états d'éclairement et détermine les deux valeurs à appliquer pour obtenir les deux distances assurant la même intensité du courant.

La figure 8 illustre les variations du coefficient de transmission en fonction de la longueur d'onde (en nm) pour le matériau photoconducteur Ag In(Cr) à l'état cristallin. Le point d'inflexion de la couche se situe aux environs de 1080 nm. Dans ce cas, la source lumineuse à utiliser pour provoquer la photoconduction peut être un laser à solide dopé au néodyme, par exemple un laser YAG dopé au néodyme, fonctionnant à 1060 nm.

La figure 9 illustre ces mêmes variations pour le matériau AgIn(Am) à l'état amorphe. Le point d'inflexion se situe à environ 850 nm. Une diode laser fonctionnant à 0,8 µm peut convenir dans ce cas.

## Revendications

1. Système de lecture d'informations comprenant un support où sont enregistrées lesdites informations, ce support comprenant un substrat (10), une couche conductrice (12), une couche d'enregistrement (15) en un matériau apte à présenter, en diverses zones, soit un état amorphe, soit un état cristallin, ce dispositif comprenant en outre au moins une micropointe (20), des moyens de déplacement (23, 25) de cette micropointe (20) pour placer celle-ci au-dessus de l'une quelconque des zones d'enregistrement du support (Za, Zc), des moyens (22) pour faire passer un courant dans la micropointe (20) et dans ladite zone (Za, Zc) et des moyens (24) pour mesurer l'intensité de ce courant, ce dispositif étant **caractérisé en ce que** :
i) le matériau de la couche d'enregistrement (15) du support est un matériau photoconducteur, avec une résistivité qui dépend de l'éclairement, ce matériau présentant une première résistance Ra en l'absence d'éclairement et une seconde résistance Ra* en présence d'éclairement pour une zone où le matériau est amorphe, une troisième résistance Rc en l'absence d'éclairement et une quatrième résistance Rc* en présence d'éclairement pour une zone où le matériau est cristallin, le rapport Ra/Ra* étant différent du rapport Rc/Rc* ;
ii) il comprend, en outre, une source lumineuse (26) apte à illuminer au moins la zone du support au-dessus de laquelle la pointe est disposée, des moyens de commande (27) de cette source lumineuse (26) pour produire un état d'éclairement ou un état de non-éclairement de ladite zone (Za*,Zc* (Za,Zc).

2. Système selon la revendication 1, dans lequel les moyens de déplacement (23-25) de la micropointe (20) sont aptes à déplacer la micropointe (20) au-dessus de la couche d'enregistrement (15), sans contact avec celle-ci.

3. Système selon la revendication 2, dans lequel les moyens de déplacement de la micropointe comprennent des moyens (25) de réglage de la distance (d) séparant la micropointe (20) de la couche d'enregistrement (15).

4. Procédé de mise en oeuvre d'un système de lecture conforme à la revendication 1, **caractérisé par le fait qu'**on mesure, pour une zone donnée de la couche d'enregistrement (15), la variation d'intensité du courant lorsqu'on passe d'un premier état d'éclairement de cette zone à un second état d'éclairement de cette même zone et l'on déduit de cette variation d'intensité la valeur de l'information enregistrée dans cette zone.

5. Procédé selon la revendication 4, dans lequel on procède en deux phases :
- dans une première phase, on place la zone à lire dans un premier état d'éclairement ou de non éclairement, on règle la distance (d) séparant la micropointe (20) de la couche d'enregistrement (15) pour obtenir une intensité égale à une valeur (Io) donnée,
- dans une seconde phase, on place la zone à lire dans un second état de non éclairement ou respectivement d'éclairement, on mesure la nouvelle valeur de l'intensité (Ia ou Ic) et l'on déduit de la variation d'intensité l'information enregistrée.

6. Procédé selon l'une quelconque des revendications 4 et 5, dans lequel, pour obtenir l'ensemble des informations enregistrées sur le support, on mesure ladite variation d'intensité, zone après zone.

7. Procédé selon l'une quelconque des revendications 4 et 5, dans lequel, pour obtenir l'ensemble des informations enregistrées sur le support, on mesure les intensités propres à chacune des zones du support en plaçant d'abord toutes ces zones dans un premier état d'éclairement, puis on mesure les intensités propres à chacune desdites zones en plaçant toutes ces zones dans un second état d'éclairement, et on en déduit, pour chaque zone, la variation d'intensité entre le premier état et le second.

8. Procédé de mise en oeuvre d'un système de lecture conforme à la revendication 1, **caractérisé par le fait qu'**on mesure, pour une zone donnée de la couche d'enregistrement (15), la variation de distance (d1, d2) entre la micropointe (20) et la couche d'enregistrement (15) qui assure au courant une intensité constante lorsqu'on passe d'un premier état d'éclairement de cette zone à un second état d'éclairement de cette même zone, et l'on déduit de cette variation de distance la valeur de l'information enregistrée dans cette zone.

9. Procédé selon la revendication 8, dans lequel on procède en deux phases :
- dans une première phase, on place la zone à lire dans un premier état d'éclairement ou de non éclairement et on règle la distance séparant la micropointe (20) de la couche d'enregistrement (15) à une première valeur (d1) pour obtenir une intensité égale à une valeur donnée (Io),
- dans une seconde phase, on place la zone à lire dans un second état de non éclairement ou respectivement d'éclairements et l'on règle à nouveau la distance séparant la micropointe (20) de la couche d'enregistrement (15) à une seconde valeur (d2) pour obtenir la même intensité (Io), et l'on déduit de l'écart entre la première valeur (d1) et la seconde (d2) l'information enregistrée.

10. Procédé selon l'une quelconque des revendications 8 et 9, dans lequel pour obtenir les informations enregistrées sur l'ensemble du support, on mesure ladite variation de distance, zone après zone.

11. Procédé selon l'une quelconque des revendications 8 et 9, dans lequel, pour obtenir les informations enregistrées sur l'ensemble du support, on place l'ensemble du support dans un premier état d'éclairement, on mesure la distance entre la micropointe (20) et la couche d'enregistrement (15) pour chaque zone du support pour obtenir une intensité donnée (Io), puis on place l'ensemble du support dans un second état d'éclairement et l'on mesure la distance entre la micropointe (20) et la couche d'enregistrement (15) pour chaque zone du support pour obtenir toujours la même intensité (Io).

## Claims

1. System for reading information comprising a medium where said information is recorded, said medium comprising a substrate (10), a conductive layer (12), a recording layer (15) of a material able to have in various zones either an amorphous state or a crystalline state, said system also comprising at least one micropoint (20), means (23, 25) for displacing said micropoint (20) in order to place it above any random one of the recording zones (Za, Zc) of the medium, means (22) for passing a current into the micropoint (20) and into said zone (Za, Zc) and means (24) for measuring the intensity of said current, said system being **characterized in that**:
i) the material of the recording layer (15) of the medium is a photoconductor material with a resistivity dependent on the illumination, said material having a first resistance (Ra) in the absence of illumination and a second resistance (Ra*) in the persence of illumination for a zone where the material is amorphous, a third ersistance (Rc) in the absence of ilumination and a fourth resistance (Rc*) in the presence of illumination for a zone where the material is crystalline, the ratio (Ra/Ra*) being different from the ratio (Rc/Rc*),
(ii) it also comprises a light source (6) able to illuminate at least the zone of the medium above which the point is located, means (27) for controlling said light source (26) for producing an illumination state or a non-illumination state of said zone (Za*, Zc*-Za, Zc).

2. System according to claim 1, wherein the displacement means (23-25) of the microprobe (20) are able to move the microprobe (20) above the recording layer (15) without contact therewith.

3. System according to claim 2, wherein the microprobe displacement means comprise means (25) for regulating the distance (d) separating the microprobe (20) from the recording layer (15).

4. Method for implementing a reading system according to claim 1, wherein, for a given zone of the recording layer (15), measurement takes place of the intensity variation of the current on passing from a first illumination state of said zone to a second illumination state of said zone and from said intensity variation is deduced the value of the information recorded in said zone.

5. Method according to claim 4, wherein operation takes place in two phases:
- in a first phase, the zone to be read is placed in a first illumination state or non-illumination state, the distance (d) separating the microprobe (20) from the recording layer (15) is regulated to obtain an intensity equal to a given value (Io),
- in a second phase, the zone to be read is placed in a second non-illumination state or illumination state respectively and the new intensity value (Ia or Ic) is measured and from it is deduced the intensity variation of the recorded information.

6. Method according to either of the claims 4 and 5, wherein, for obtaining all the information recorded on the medium, said intensity variation is measured zone by zone.

7. Method according to either of the claims 4 and 5, wherein, to obtain all the information recorded on the medium, measurement takes place of the intensities for each of the zones of the medium by firstly placing all these zones in a first illumination state, followed by the measurement of the intensities of each of said zones by placing all said zones in a second illumination state and from it is deduced for each zone the intensity variation between the first and second states.

8. Method for implementing a reading system according to claim 1, wherein, for a given zone of the recording layer (15), measurement takes place of the distance variation (d1, d2) between the microprobe (20) and the recording layer (15), which ensures that the current has a constant intensity on passing from a first illumination state of said zone to a second illumination state of said zone and from the distance variation is deduced the value of the information recorded in said zone.

9. Method according to claim 8, wherein operation takes place in two phases:
- in a first phase, the zone to be read is placed in a first illumination state or non-illumination state and the distance separating the microprobe (20) from the recording layer (15) is regulated to a first value (d1) in order to obtain an intensity equal to a given value (Io),
- in a second phase, the zone to be read is placed in a second non-illumination state or illumination state respectively and once again the distance separating the microprobe (20) from the recording layer (15) is regulated to a second value (d2) to obtain the same intensity (Io) and from the difference between the first value (d1) and the second value (d2) the recorded information is deduced.

10. Method according to either of the claims 8 and 9, wherein to obtain the information recorded on the entire medium, the distance variation is measured zone by zone.

11. Method according to either of the claims 8 and 9, wherein, to obtain the information recorded on the entire medium, the complete medium is placed in a first illumination state, the distance between the microprobe (20) and the recording layer (15) for each zone of the medium is measured in order to obtain a given intensity (Io) and then the complete medium is placed in a second illumination state and the distance between the microprobe (20) and the recording layer (15) is measured for each zone of the support in order to obtain the same intensity (Io) in each case.

## Patentansprüche

1. System zum Wiedergeben bzw. Lesen von Informationen, mit einem Träger zur Aufzeichnung der genannten Informationen, wobei dieser Träger ein Substrat (10), eine leitende Schicht (12), eine Aufzeichnungsschicht (15) aus einem Material umfasst, das sich, in verschiedenen Zonen, entweder in einem amorphen Zustand oder einem kristallinem Zustand befindet, wobei dieses System außerdem wenigstens eine Mikrospitze (20) und Verschiebungseinrichtungen (23, 25) dieser Mikrospitze (20), um diese über irgendeiner der Aufzeichnungszonen (Za, Zc) des Trägers in Stellung zu bringen, und Einrichtungen (22) zum Einspeisen eines Stroms in die Mikrospitze (20) und in die genannte Zone (Za, Zc), sowie Einrichtungen zum Messen der Stärke dieses Stroms umfasst, und dieses System dabei
**dadurch gekennzeichnet** ist:
i) dass das Material der Aufzeichnungsschicht (15) des Trägers ein Photoleitermaterial ist, dessen Resistivität von der Helligkeit bzw. Beleuchtung abhängt, wobei dieses Material für eine Zone, in der das Material amorph ist, bei Fehlen von Beleuchtung einen ersten Widerstand Ra hat, bei Vorhandensein von Beleuchtung einen zweiten Widerstand Ra* hat, sowie für eine Zone, in der das Material kristallin ist, bei Fehlen von Beleuchtung einen dritten Widerstand Rc hat, und bei Vorhandensein von Beleuchtung einen vierten Widerstand Rc* hat, wobei das Verhältnis Ra/Ra* anders ist als das Verhältnis Rc/Rc*;
ii) dass es außerdem eine-Lichtquelle (26) umfasst, die wenigstens die Zone des Trägers beleuchtet, über der die Spitze angeordnet ist, sowie Steuereinrichtungen (27) dieser Lichtquelle (26) umfasst, um einen Beleuchtungszustand oder einen Nichtbeleuchtungszustand der genannten Zone (Za*, Zc* (Za, Zc) herzustellen.

2. System nach Anspruch 1, bei dem die Verschiebungseinrichtungen (23-25) der Mikrospitze die Mikrospitze (20) über der Aufzeichnungsschicht (15) in Stellung bringen können, ohne Kontakt mit dieser.

3. System nach Anspruch 1, bei dem die Verschiebungseinrichtungen der Mikrospitze Einrichtungen (25) zur Regelung bzw. Einstellung des Abstands (d) umfassen, der die Mikrospitze (20) von der Aufzeichnungsschicht (15) trennt.

4. Verfahren zur Anwendung eines Wiedergabe- bzw. Lesesystems nach Anspruch 1, **dadurch gekennzeichnet, dass** man für eine bestimmte Zone der Aufzeichnungsschicht (15) die Intensitätsveränderung des Stroms misst, wenn man von einem ersten Beleuchtungszustand dieser Zone in einen zweiten Beleuchtungszustand dieser selben Zone übergeht, und dass man aus dieser Intensitätsveränderung den Wert der in dieser Zone aufgezeichneten Information ableitet.

5. Verfahren nach Anspruch 4, bei dem man in zwei Phasen vorgeht:
- in einer ersten Phase versetzt man die zu lesende Zone in einen ersten Beleuchtungsoder Nichtbeleuchtungszustand und stellt den die Mikrospitze (20) von der Aufzeichnungsschicht (15) trennenden Abstand (d) ein, um eine Intensität gleich einem bestimmten Wert (Io) zu erhalten,
- in einer zweiten Phase versetzt man die zu lesende Zone in einen zweiten Zustand der Nichtbeleuchtung oder jeweils Beleuchtung, misst den neuen Intensitätswert (la oder Ic) und leitet aus der Intensitätsveränderung die aufgezeichnete Information ab.

6. Verfahren nach einem der Ansprüche 4 und 5, bei dem man, um die Gesamtheit der in dem Träger aufgezeichneten Informationen zu erhalten, Zone für Zone die genannte Intensitätsveränderung misst.

7. Verfahren nach einem der Ansprüche 4 und 5, bei dem man, um die Gesamtheit der in dem Träger aufgezeichneten Informationen zu erhalten, die für jede der Zonen des Trägers charakteristischen Intensitäten misst, indem man zunächst alle diese Zonen in einen ersten Beleuchtungszustand versetzt, dann die für jede dieser Zonen charakteristischen Intensitäten misst, indem man alle diese Zonen in einen zweiten Beleuchtungszustand versetzt, und man daraus für jede Zone die Intensitätsveränderung zwischen dem ersten und dem zweiten Zustand ableitet.

8. Verfahren zu Anwendung eines Wiedergabe- bzw. Lesesystems nach Anspruch 1, **dadurch gekennzeichnet, dass** man für eine bestimmte Zone der Aufzeichnungsschicht (15) die Abstandsveränderung (d1, d2) zwischen der Mikrospitze (20) und der Aufzeichnungsschicht (15) misst, die dem Strom eine konstante Intensität sichert, wenn man von dem ersten Beleuchtungszustand dieser Zone in einen zweiten Beleuchtungszustand dieser selben Zone übergeht, und dass man aus dieser Abstandsveränderung den Wert der in dieser Zone aufgezeichneten Information ableitet.

9. Verfahren nach Anspruch 8, bei dem man in zwei Phasen vorgeht:
- in einer ersten Phase versetzt man die zu lesende Zone in einen ersten Beleuchtungsoder Nichtbeleuchtungszustand und stellt den die Mikrospitze (20) von der Aufzeichnungsschicht (15) trennenden Abstand auf einen ersten Wert (d1) ein, um eine Intensität gleich einem bestimmten Wert (Io) zu erhalten,
- in einer zweiten Phase versetzt man die zu lesende Zone in einen zweiten Zustand der Nichtbeleuchtung oder jeweils Beleuchtung, und wieder stellt man den die Mikrospitze (20) von der Aufzeichnungsschicht (15) trennenden Abstand auf einen zweiten Wert (d2) ein, um dieselbe Intensität (Io) zu erhalten, und man leitet aus dem Abstand zwischen dem ersten Wert (d1) und dem zweiten Wert (d2) die aufgezeichnete Information ab.

10. Verfahren nach einem der Ansprüche 8 und 9, bei dem man, um die Gesamtheit der in dem Träger aufgezeichneten Informationen zu erhalten, Zone für Zone die genannte Abstandsveränderung misst.

11. Verfahren nach einem der Ansprüche 8 und 9, bei dem man, um die Gesamtheit der in dem Träger aufgezeichneten Informationen zu erhalten, man den ganzen Träger in einen ersten Beleuchtungszustand versetzt, man den Abstand zwischen der Mikrospitze (20) und der Aufzeichnungsschicht (15), um eine bestimmte Intensität (Io) zu erhalten, für jede Zone des Trägers misst, man dann, um wieder dieselbe Intensität (Io) zu erhalten, den ganzen Träger in einen zweiten Beleuchtungszustand versetzt und man den Abstand zwischen der Mikrospitze (20) und der Aufzeichnungsschicht (15) misst.
